# EUROPEAN PATENT APPLICATION

(11) **EP 2 660 981 A2**
(43) Date of publication of application: **06.11.2013**
(21) Application number: 13164774.5
(22) Date of filing: 22.04.2013
(51) Int. Cl.: H03K 17/96

(54) **Operator control assembly**

(30) Priority: 30.04.2012 US 201213459581
(71) Applicant: Delphi Technologies, Inc., Troy, MI 48007 (US)
(72) Inventor: Snider, Chris R., Noblesville, Indiana 46062-4196 (US); Coon, Bradley S., Russiaville, Indiana 46979 (US)
(74) Representative: Allain, Michel Jean Camille

(57) **Abstract**

A control assembly (10) adapted for automotive applications provides operator inputs and displays and includes a uniface ornamental escutcheon (12) defining a central display area (26) and a plurality of operator input devices (28 - 54) at least partially circumscribing the display area. Each operator input device includes a faux control member integrally formed within the escutcheon and having beveled circumferential contours mimicking a discrete displaceable control element. At least one substrate (56 - 60) extends rearwardly from and closely conforms with a rear surface of the escutcheon, and is positioned to transect a plurality of adjacent faux control members. At least one capacitance sensor (64 - 70, 86 - 92, 110 - 116) is associated with each faux control member and is carried on a forward facing edge of the substrate. As a result, each operator input device is touch sensitive to manual operator selection of input devices by touching the exposed face of the escutcheon to effect a desired switching function.

## Description

### TECHNICAL FIELD

The present invention relates to control devices for enabling operator inputs and system displays, and more particularly, the application of capacitance user-interface switches in such devices.

### BACKGROUND OF THE INVENTION

Capacitance switching circuits are typically configured on the planar surface of a circuit board whether it is a rigid substrate like an FR4 material or a flexible substrate like a polyamide film. This approach has limitations on the design for providing switch illumination and pushbutton layouts, especially when the switches border a display area or with complex curved areas commonly found on control front end styling. Flexible circuits can adapt but generally are more expensive and require an adhesive interface to ensure intimate contact with the pushbutton are a material to enable energy transfer to the switch.

### SUMMARY OF THE INVENTION

By plating the edge of a circuit board at an intended capacitance switch area, almost any curved surface can be replicated with the circuit board edge to enable the intimate contact needed with a trim plate for efficient energy transfer without using an expensive flex circuit or adding a silicone gap filling compound in conjunction with the planar surface. Since primarily only a circuit board edge is needed for the switch, the open area can enable a flood lit volume of space for illumination or light pipe access for a controlled light dispersion as opposed to using individual light emitting diodes (LED) for each pushbutton graphic/switch area.

The circuit board efficiency is realized by providing the switch circuitry in only the required area leaving the additional surface available for interconnections or other componentry. In addition, by using an overlapping circuit board running in a perpendicular fashion to the main switch board, a rotary function can be realized with the contact pad locations at the 3 o'clock, 6 o'clock, 9 o'clock and 12'oclock positions. This can be especially beneficial when integrated with a vehicular audio or navigation system that uses a display with the sides and either top row or bottom row of pushbuttons where there may be a typical rotary style control at the corners where the rows of switches intersect.

In the preferred embodiment of the invention a control assembly for providing operator inputs and displays includes a uniface ornamental escutcheon forming a display area and a plurality of operator input devices at least partially circumscribing the display area. Each said operator input device forms a faux control member integrally within the escutcheon having beveled circumferential contours mimicking a discrete relatively displacable control element. At least one substrate extends normally rearwardly from a rear facing surface of said escutcheon, said substrate including a front edge surface configured to closely conform to the rear facing surface of the escutcheon and transecting a plurality of adjacent faux control members. One or more capacitance sensors associated with each faux control member carried on the front edge surface of said substrate, said at least one capacitance sensor is adapted to sense a change in capacitance at said front edge surface resulting from proximate engagement with an associated faux control member by an object having predetermined capacitance characteristics. Lastly, capacitance change responsive switching circuitry carried on said substrate and in-circuit with said at least one capacitance sensor for providing a desired switching function responsive to said engagement. This provides a control assembly which is inexpensive and simple to build which faithfully mimics the overall appearance and functionality of traditional control assemblies.

Also, at least one of said faux control members includes a translucent light path (240) extending there-through, and said control assembly further comprises a light source (242) carried on said substrate in-circuit with said switching circuitry and focused on said translucent light path to affect external illumination of said at least one faux control member.

Moreover, at least of said operator input devices comprises a faux push button device (28 - 50), a faux slider device (146) and also a faux rotary knob device (52, 54)

Moreover, at least one capacitance sensor comprises conductive edge plating segments disposed on said front edge surface of said substrate, which comprises a flexible printed circuit board (214), a substantially rigid printed circuit board (56, 58, 60). Further at least one rigid printed circuit board (one substrate) comprises a first printed circuit board extending in a first axial direction transecting a first group of adjacent faux control members, and a second printed circuit board extending in a second axial direction transecting a second group of adjacent faux control members, such as the first and the second groups of adjacent faux control members define respective peripheral edges of said escutcheon display area, such as the first and second printed circuit boards are normally disposed to define an intersection point corresponding with a faux rotary knob member. This one (faux rotary knob member) is associated with a knob-type input device further comprising a plurality of circumferentially arranged capacitance sensors formed on the leading edges of both said printed circuit boards about said intersection point.

It also includes the capacitance change responsive switching circuitry, which is operative to simultaneously sense the capacitance change of all of said circumferentially arranged capacitance sensors (76, 78, 122, 124) and to calculate the effective point of engagement of said object having predetermined capacitance characteristics vis-a-vis said faux rotary knob. The capacitance change responsive switching circuitry is operative to generate a first signal mimicking rotary repositioning of the faux knob in response to only one or two of the capacitive sensors sensing said change in capacitance. The capacitance change responsive switching circuitry is also operative to generate a second signal mimicking axial repositioning of the faux knob in response to only three or more of the capacitive sensors sensing said change in capacitance.

The faux slider device comprises a linear array of capacitance sensors (160 - 168) carried on said substrate front edge surface (154) commonly interconnected with said capacitance change responsive switching circuitry.

Further it comprises a linear array of tactile denticles (156A - 156D) integrally formed in the outer surface of said escutcheon in aligned juxtaposition with said array of capacitance sensors. It includes also relatively large denticles (158) at each end of said linear array, and reduced dimension denticles disposed there between.

These and other features and advantages of this invention will become apparent upon reading the following specification, which, along with the drawings, describes preferred and alternative embodiments of the invention in detail.

### BRIEF DESCRIPTION OF THE DRAWINGS

The present invention will now be described, by way of example, with reference to the accompanying drawings, in which:

FIG. 1, is an exploded, perspective view of a first embodiment of a vehicle control assembly featuring a plurality of faux push-button devices circumscribing a display area and two faux rotary knob devices;

FIG. 2, is a front plan view of the vehicle control assembly of Figure 1;

FIG. 3, is a cross-sectional, plan view of the vehicle control assembly of Figure 1, taken along lines 3 - 3 of Figure 2;

FIG. 4, is a cross-sectional plan view of one of the faux rotary knob devices of Figure 1, taken along lines 4-4 of Figure 3;

FIG. 5, is an exploded, perspective view of a second embodiment of a vehicle control assembly featuring a faux slider device;

FIG. 6, is a broken, cross-sectional view of a portion of a second embodiment of a vehicle control assembly; and

FIG. 7, is a broken, perspective view of a portion of a third embodiment of a vehicle control assembly.

Although the drawings represent embodiments of the present invention, the drawings are not necessarily to scale and certain features may be exaggerated in order to illustrate and explain the present invention. The exemplification set forth herein illustrates an embodiment of the invention, in one form, and such exemplifications are not to be construed as limiting the scope of the invention in any manner.

### DESCRIPTION OF THE PREFERRED EMBODIMENT

In its preferred embodiment, the present invention is described as an automotive trim panel for providing an operator interface with an audio or navigation system or the like.

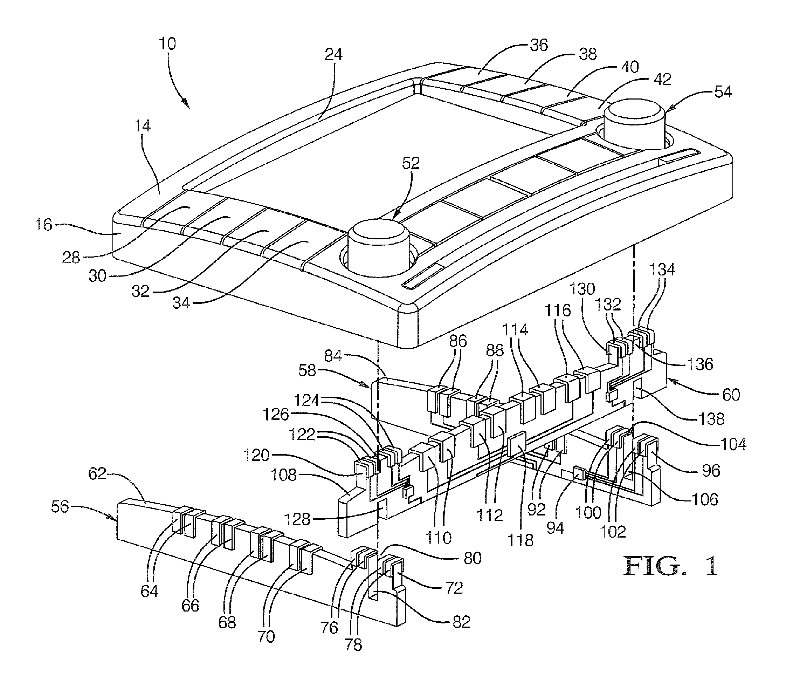

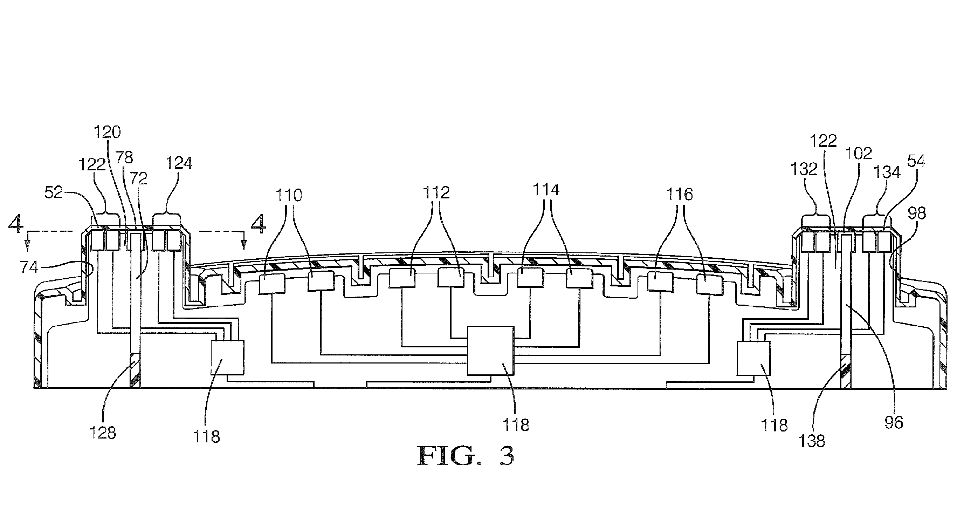

Referring to Figures 1 - 4, a first embodiment of the present invention illustrates a control assembly 10 operative to provide operator inputs and displays for a host vehicle (not illustrated). The control assembly 10 is adapted for mounting in the instrument panel of the host vehicle and includes a shell-shaped ornamental escutcheon 12, preferably formed of injection molded polymer based material in a single, unified structure.

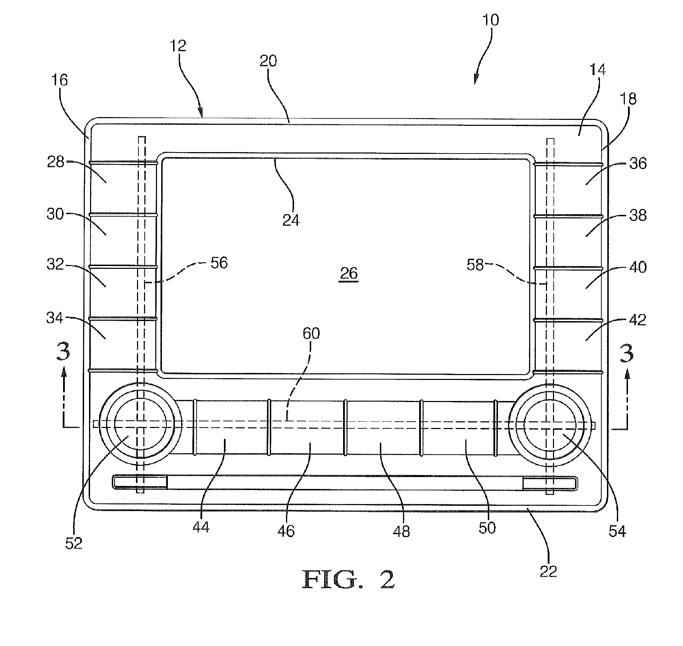

As best viewed in Figures 1 and 2, the escutcheon 12 is shaped in a generally rectangular form including a front wall or face portion 14, left and right side walls 16 and 18, respectively, and top and bottom walls 20 and 22, respectively. Preferably, the front wall 14 is integrally molded as a single piece with the respective walls 16 - 22, which, in application, extend rearwardly therefrom. A generally centralized rectangular opening 24 is formed in the front wall 14 to define a display area 26 for receiving a liquid crystal display (LCD) or equivalent device (not illustrated).

Referring to Figure 2, a vertically arranged array of four faux pushbuttons 28, 30, 32 and 34 define the left-hand edge of opening 24. Likewise, a second vertically arranged array of four faux pushbuttons 36, 38, 40 and 42 define the right-hand edge of opening 24. A horizontally arranged array of four faux pushbuttons 44, 46, 48 and 50 define the bottom edge of opening 24. A first faux rotary knob 52 is located at the intersection of the respective lines of elongation of the vertical array of push-buttons 28 - 34 and the horizontal array of push-buttons 44 - 50. A second faux rotary knob 54 is located at the intersection of the respective lines of elongation of the vertical array of push-buttons 36 - 42 and the horizontal array of push-buttons 44 - 50.

The faux push-buttons 28 - 50 and faux rotary knobs 52 and 54 are each integrally formed from the same polymer based material comprising the ornamental escutcheon 12. Each of the faux push-buttons 28 - 50 and faux rotary knobs 52 and 54 are formed as an integral part of the front wall or face portion 14 of the ornamental escutcheon 12. Definitionally, the ornamental escutcheon 12 is deemed to be "uniface", meaning that all of the faux control members (faux push button device, faux slider device and faux rotary knob device) are integrally formed on the curvilinear plane defined by the front wall/face portion 14 of the ornamental escutcheon. No faux control members are formed in the walls 16 - 22.

Conventional audio systems, such as the automotive radio/CD played described, typically include a trim plate assembly carrying a complex assemblage of discrete operator accessible control devices, such as rotary knobs and pushbuttons, which are physically displacable with respect to the trim plate. Each faux control member 28 - 54 has molded-in features such as beveled circumferential contours enabling them to mimic their conventional discrete counterpart and enabling the overall cosmetic appearance of the control assembly to mimic a conventional trim panel assembly.

Referring to Figures 1 - 4, each faux control member 28 - 54 constitutes an external surface "target area" or "touch point" for an operator to affect an input command to a specific host vehicle system via the control assembly 10. In the case of the push buttons 28 - 50, each target area is a generally rectangular surface with peripheral contours and recesses providing the false appearance of discrete, separate control elements which are separately displaceable during operator actuation.

The control assembly 10 further includes three elongated substrates, such as rigid printed circuit boards (PCBs) 56, 58 and 60, mounted to the rear surface of the escutcheon 12 and carrying electrical circuitry as will be further described herein below. The PCBs 56 - 60 are disposed substantially normally to and extend longitudinally rearwardly from the rear facing surface of the front wall 14 of the escutcheon 12.

PCB 56 is disposed vertically transecting push buttons 28 - 34 and faux rotating knob 52. PCB 56 has a front edge surface 62 shaped to generally conform with the adjacent rear facing surface of the front wall 14. Four capacitive sensors 64, 66, 68 and 70 are carried on the front edge surface 62 of PCB 56 and are positioned to register with faux push buttons 28 - 34, respectively. Each of the sensors 64 - 70 comprise a pair of spaced-apart contacts electrically interconnected with capacitance change switching circuitry (not illustrated) also carried on PCB 56. PCB 56 has an extension portion 72 nestingly extending within a cavity 74 defined by faux rotary knob 52. Upper and lower capacitive sensors, 76 and 78, respectively, are carried on the upper surface 80 of extension part 72, separated by a guide slot 82.

Definitionally, "operator input devices" consist of a faux control member, at least one associated capacitive sensor and the associated capacitance change switching circuitry. By example, the upper left-hand most (push-button type) operator input device comprises faux push button 28, capacitive sensor 64 and its associated capacitance change switching circuitry.

PCB 58 is disposed vertically transecting push buttons 36 - 42 and faux rotating knob 54. PCB 58 has a front edge surface 84 shaped to generally conform with the adjacent rear facing surface of the front wall 14. Four capacitive sensors 86, 88, 90 and 92 are carried on the front edge surface 84 of PCB 58 and are positioned to register with faux push buttons 36 - 42, respectively. Each of the sensors 86 - 92 comprise a pair of spaced-apart contacts electrically interconnected with capacitance change switching circuitry 94 also carried on PCB 58. PCB 58 has an extension portion 96 nestingly extending within a cavity 98 defined by faux rotary knob 54. Upper and lower capacitive sensors, 100 and 102, respectively, are carried on the upper surface 104 of extension part 96, separated by a guide slot 106.

PCB 60 is disposed horizontally transecting push buttons 44 - 50 and faux rotating knobs 52 and 54. PCB 60 has a front edge surface 108 shaped to generally conform with the adjacent rear facing surface of the front wall 14. Four capacitive sensors 110, 112, 114 and 116 are carried on the front edge surface 108 of PCB 60 and are positioned to register with faux push buttons 44 - 50, respectively. Each of the sensors 110 - 116 comprise a pair of spaced-apart contacts electrically interconnected with capacitance change switching circuitry 118 also carried on PCB 60. PCB 60 has a first extension portion 120 nestingly extending within the cavity 74 defined by faux rotary knob 52. Left and right capacitive sensors, 122 and 124, respectively, are carried on the upper surface 126 of extension portion 120, laterally separated by a guide slot 128. PCB 60 has a second extension portion 130 nestingly extending within the cavity 98 defined by faux rotary knob 54. Left and right capacitive sensors, 132 and 134, respectively, are carried on the upper surface 136 of extension portion 130, laterally separated by a guide slot 128.

By second example, the lower left-hand most (rotary knob type) operator input device comprises faux rotary knob 52, capacitive sensors 76, 78, 122 and 124 and their associated capacitance change switching circuitry.

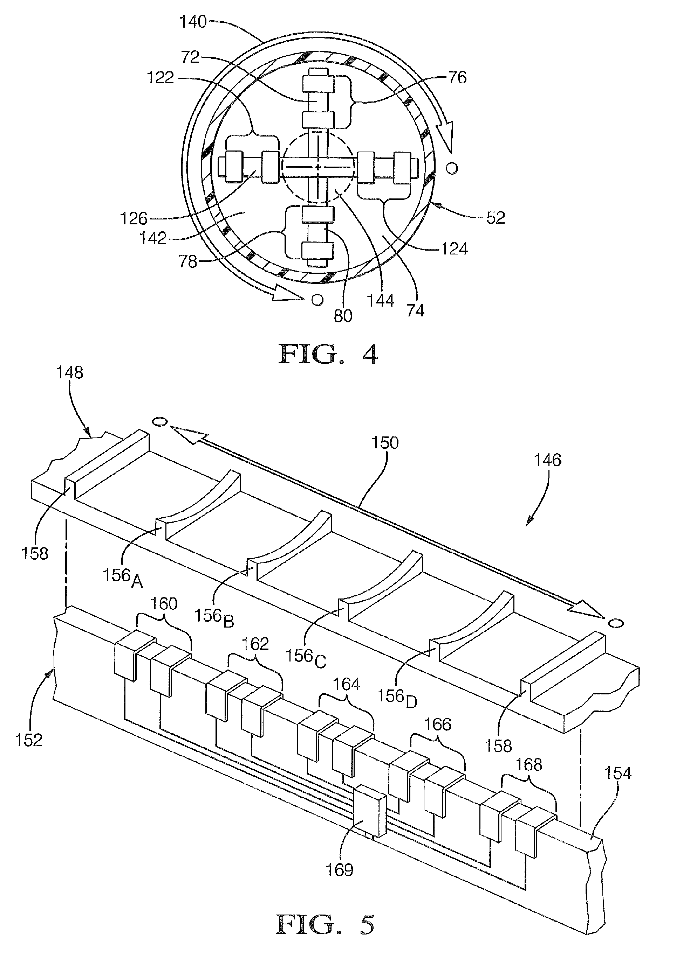

Referring to Figure 4, the positioning of multiple (in this case - 4) separate capacitance sensors at fixed orientations within a faux rotary knob 52 allows the operator to affect a mock rotation of the knob 52 by rotating one or more finger tips around the circumference as depicted by arrow 140 about axis 141. Each of the capacitive sensors 76, 78, 122 and 124 are separately in circuit with capacitive change responsive switching circuitry. The faux knob 52 has a first, outer sensing region 142, wherein proximity of an operator's fingertip is detected by one or two of the capacitive sensors 76, 78, 122 and 124, and second, inner sensing region 144, wherein proximity of an operator's fingertip is detected by three or four of the capacitive sensors 76, 78, 122 and 124. An operator's fingertip, when sensed is located based upon which single capacitive sensor detects it or if detected by two capacitive sensors, by triangulation. For example, if the fingertip affects a similar response by sensors 122 and 76, it is deduced that the fingertip is located in the third quadrant, i.e. the 10:00 - 11:00 o'clock position and a rotary motion control signal is produced. An operator's fingertip, when sensed by three or four capacitive sensors simultaneously is deduced to be located in the inner sensing region 144 to affect actuation of a push-button actuator circuit.

Referring to Figure 5, a faux slider device 146 is illustrated, including a relatively fixed, decorative exposed panel 148 defining an elongated region of control depicted by an arrow 150, and an underlying PCB 152 having a front edge surface 154. A number of spaced apart tactile protuberances or denticles 156a - 156D and end of travel stops 158 are integrally formed in the panel 148 and are shaped to provide the operator a tactile input as to the relative position of his fingertip between the stops 158. Five capacitive sensors 160, 162, 164, 166 and 168 are carried on the front edge 154 of the PCB 152 in spaced apart relationship and in respective registry with the spacing between adjacent denticles 156A - 156D and stops 158. The sensors 160 - 168 are in circuit with capacitive change switching circuitry 169 also carried on the PCB 152.

The faux slider 146 has a plurality of aligned sensing regions, wherein proximity of an operator's fingertip is detected by one or two of the capacitive sensors 160, 162, 164, 166 and 168 to provide an analog switch signal representative of finger location.

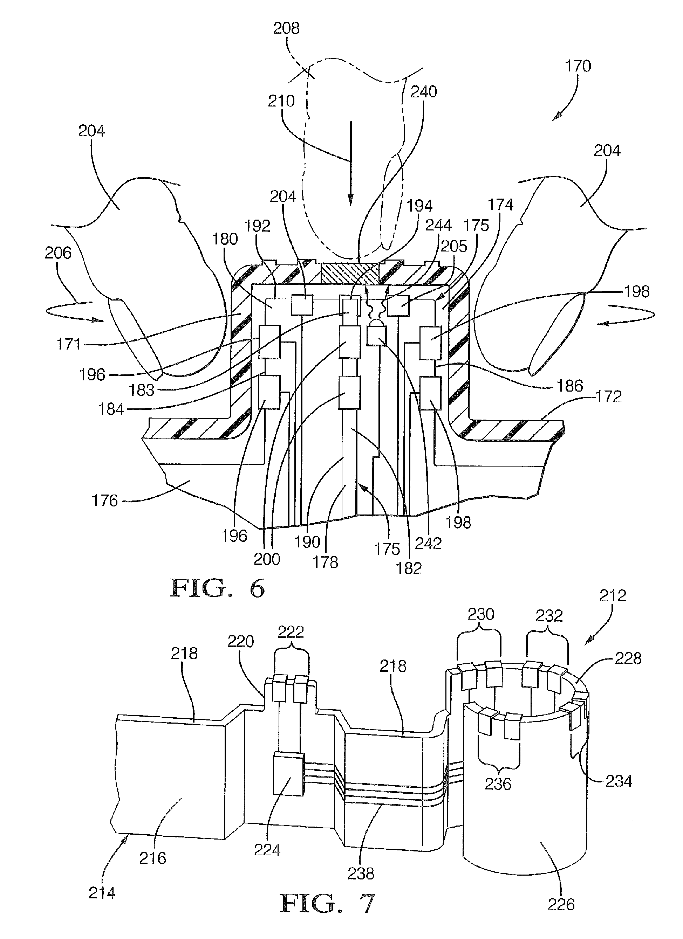

Referring to Figure 6, an alternative faux rotary knob device 170 is illustrated, similar to the faux knobs 52 and 54 depicted in Figures 1 - 4. The faux knob device 170 has a knob structure 171 integrally formed with an ornamental escutcheon 172 to define a cavity 174. An interlocked pair of rigid PCBs 176 and 178 have extensions 180 and 182, respectively, nestingly disposed within cavity 174. PCB extension 180 has opposed lateral edges 184 and 186 and PCB extension 182 has opposed lateral edges 188 and 190. PCB extension 180 has an upper surface 192 and PCB extension 182 has an upper surface 194. Capacitive sensors 196 and 198 are formed on opposed lateral edges 184 and 186 of PCB extension 180, respectively. Capacitive sensors 200 and 202 are similarly formed on opposed lateral edges 188 and 190 of PCB extension 182, respectively. The capacitive sensors 196 - 202 are cooperatively arranged in a circular array to mimic rotary motion as illustrated by a pair of fingertips 204 and rotational arrow 206. An axially centered separate capacitive sensor 204 is formed on one or both upper surfaces 192 and 194 of PCB extensions 180 and 182, respectively, to mimic axial push-button type action as illustrated by a phantom fingertip 208 and associated axially directed arrow 210.

Referring to Figure 7, an alternative control assembly 212 includes a flexible printed circuit board (PCB) 214 having an elongated strip-like body portion 216 defining a front edge surface 218 configured for installation within an ornamental escutcheon (not illustrated) similar to that illustrated in Figures 1 - 4. The body portion 216 of the PCB 214 includes a localized extension portion 220 extending above the front edge surface 218 carrying a capacitive sensor 222 electrically in circuit with a capacitive change switching circuit 224. A body end portion 226 of PCB 214 has an enlarged extension portion 228 extending above the front edge surface 218 of the PCB 214 carrying four (or more) spaced apart capacitive sensors 230, 232, 234 and 236. In application, the body end portion 226 is rolled up in a cylindrical form dimensioned for installation within a faux rotating knob cavity (not illustrated). The longitudinal length of the body end portion 226 will approximately equal the inner circumference of the faux rotating knob cavity, and the vertical extension dimension extension portion 228 will approximately equal the axial dimension of the faux rotating knob cavity. When installed, the capacitive sensors 230 - 236 will be disposed in a circular array within an associated faux rotary knob and operate similarly to the capacitive sensors 76, 78, 124 and 126 of Figures 1 - 4 and capacitive sensors 196, 198, 200 and 202 of Figure 6. Capacitive sensors 230 - 236 are electrically in circuit with capacitive change switching circuit 224 via flexible conductors 238 laterally dressed along the body portion 216 of the flexible PCB 214.

Referring to Figure 6, the touch target faux rotary knob 170 can include a window 240 or indicia formed of clear or translucent material in the molding process. A light source, such as a light emitting diode 242 is preferably mounted on one of the PCBs behind the window 240 and in circuit with the switch circuit to controllably illuminate the window 240 from behind as illustrated by arrows 244. Such illumination can be provided with all types of faux control members.

The use of capacitive touch switch technology boosts operator interface options and allows the elimination of multiple mechanical switch devices with their inherent cost and complexity while enabling packaging of switch functionality in highly curvilinear packages. Furthermore, as described herein, capacitive touch switch technology can be employed to provide faux traditional mechanical switch configurations, without their inherent cost and complexity.

It is to be understood that the invention has been described with reference to specific embodiments and variations to provide the features and advantages previously described and that the embodiments are susceptible of modification as will be apparent to those skilled in the art.

Furthermore, it is contemplated that many alternative, common inexpensive materials can be employed to construct the basis constituent components. Accordingly, the forgoing is not to be construed in a limiting sense.

The invention has been described in an illustrative manner, and it is to be understood that the terminology, which has been used is intended to be in the nature of words of description rather than of limitation.

Obviously, many modifications and variations of the present invention are possible in light of the above teachings. It is, therefore, to be understood that within the scope of the appended claims, wherein reference numerals are merely for illustrative purposes and convenience and are not in any way limiting, the invention, which is defined by the following claims as interpreted according to the principles of patent law, including the Doctrine of Equivalents, may be practiced otherwise than is specifically described.

## Claims

1. A control assembly (10) operative to provide operator inputs and displays for a host vehicle, said control assembly comprising:
a uniface ornamental escutcheon (12) defining a display area (26) and a plurality of operator input devices (28 - 54) at least partially circumscribing the display area, each said operator input device forming a faux control member integrally within the escutcheon having beveled circumferential contours mimicking a discrete relatively displacable control element;
at least one substrate (56 - 60) extending normally rearwardly from a rear facing surface of said escutcheon, said substrate including a front edge surface (62, 84, 108) configured to closely conform to the rear facing surface of the escutcheon and transecting a plurality of adjacent faux control members;
at least one capacitance sensor (64 - 70, 86 - 92, 110 - 116) associated with each faux control member carried on the front edge surface of the substrate, said at least one capacitance sensor adapted to sense a change in capacitance at the front edge surface resulting from proximate engagement with an associated faux control member by an object having predetermined capacitance characteristics; and
capacitance change responsive switching circuitry (94, 118) carried on th esubstrate and in-circuit with said at least one capacitance sensor for providing a desired switching function responsive to the engagement.

2. The control assembly of claim 1, wherein at least one of the faux control members include a translucent light path (240) extending there-through, and the control assembly further comprises a light source (242) carried on the substrate in-circuit with the switching circuitry and focused on the translucent light path to affect external illumination of said at least one faux control member.

3. The control assembly of claim 1, wherein at least of the operator input devices comprises a faux push button device (28 - 50).

4. The control assembly of claim 1, wherein at least of the operator input devices comprises a faux slider device (146).

5. The control assembly of claim 1, wherein at least of the operator input devices comprises a faux rotary knob device (52, 54).

6. The control assembly of claim 1, wherein said at least one capacitance sensor comprises conductive edge plating segments disposed on the front edge surface of the substrate, comprises a flexible (214)printed circuit board, a substancially rigid printed circuit board (56,58,60).

7. The control assembly of claim 6, wherein said at least one substrate comprises a first printed circuit board extending in a first axial direction transecting a first group of adjacent faux control members, and a second printed circuit board extending in a second axial direction transecting a second group of adjacent faux control members. The first and the second group of adjacent faux control members define respective peripheral edges of the escutcheon display area.

8. The control assembly of claim 7, wherein the first and second printed circuit boards are normally disposed to define an intersection point corresponding with a faux rotary knob member.

9. The control assembly of claim 8, wherein the faux rotary knob member is associated with a knob-type input device further comprising a plurality of circumferentially arranged capacitance sensors formed on the leading edges of both said printed circuit boards about said intersection point.Further the capacitance change responsive switching circuitry is operative to simultaneously sense the capacitance change of all of said circumferentially arranged capacitance sensors (76, 78, 122, 124) and to calculate the effective point of engagement of said object having predetermined capacitance characteristics vis-a-vis said faux rotary knob.

10. The control assembly of claim 9, wherein the capacitance change responsive switching circuitry is operative to generate a first signal mimicking rotary repositioning of the faux knob in response to only one or two of the capacitive sensors sensing said change in capacitance, and a second signal mimicking axial repositioning of the faux knob in response to only three or more of the capacitive sensors sensing said change in capacitance.

11. The control assembly of claim 9, wherein the capacitance change responsive switching circuitry is operative to generate a second signal mimicking axial repositioning of the faux knob in response to only three or more of the capacitive sensors sensing said change in capacitance.

12. The control assembly of claim 4, wherein the faux slider device comprises a linear array of capacitance sensors (160 - 168) carried on the substrate front edge surface (154) commonly interconnected with said capacitance change responsive switching circuitry.

13. The control assembly of claim 12, wherein the faux slider device further comprises a linear array of tactile denticles (156A - 156D)integrally formed in the outer surface of the escutcheon in aligned juxtaposition with the array of capacitance sensors.

14. The control assembly of claim 13, wherein the faux slider device further comprises relatively large denticles (158) at each end of the linear array, and reduced dimension denticles disposed therebetween.
